# EUROPÄISCHE PATENTSCHRIFT

(11) **EP 3 034 529 B1**
(45) Veröffentlichungstag und Bekanntmachung des Hinweises auf die Patenterteilung: **14.06.2017**
(21) Anmeldenummer: 14199292.5
(22) Anmeldetag: 19.12.2014
(51) Int. Cl.: C08F 255/02, C09D 123/04, C08F 226/06, H01L 31/00, C09D 4/06

(54) **COVERNETZERSYSTEME FÜR VERKAPSELUNGSFOLIEN UMFASSEND (METH)ACRYLAMIDVERBINDUNGEN**
COVER NET SYSTEMS FOR ENCAPSULATION FILMS COMPRISING (METH)ACRYLAMIDE COMPOUNDS
SYSTÈME DE CO-RÉTICULATION POUR FEUILLES D'ENCAPSULAGE COMPRENANT DES COMBINAISONS DE (MÉTH)ACRYLAMIDE

(43) Veröffentlichungstag der Anmeldung: 22.06.2016
(73) Patentinhaber: Evonik Degussa GmbH, 45128 Essen (DE)
(72) Erfinder: Ulbricht, Dr. Daniel,, 64295 Darmstadt (DE); Hein, Marcel, 63843 Niedernberg (DE); Kleff, Frank, 63486 Bruchköbel-Oberissigheim (DE); Schauhoff, Dr. Stephanie, 63225 Langen (DE); Ohlemacher, Jürgen, 61118 Bad Vilbel (DE)

(56) Entgegenhaltungen:
- EP-A1- 1 164 167
- EP-A2- 0 227 470
- WO-A1-2008/053810
- WO-A1-2014/129573
- WO-A2-02/42342
- CN-A- 103 804 774
- CN-B- 102 504 715

## Beschreibung

Die vorliegende Erfindung betrifft eine erste Zusammensetzung **(Z)** umfassend (i) mindestens eine Verbindung **(I)** ausgewählt aus der Gruppe bestehend aus Triallylisocyanurat, Triallylcyanurat, wobei die Verbindung **(I)** bevorzugt Triallylisocyanurat ist; und (ii) mindestens eine (Meth)acrylamidverbindung. Daneben betrifft die vorliegende Erfindung auch eine zweite Zusammensetzung **(B)** umfassend die erste Zusammensetzung **(Z)** und mindestens ein Polyolefincopolymer. Schließlich betrifft die vorliegende Erfindung die Verwendung der Zusammensetzung **(B)** zur Herstellung einer Folie zur Verkapselung einer elektronischen Vorrichtung, insbesondere einer Solarzelle.

### Hintergrund der Erfindung

Photovoltaikmodule (Photovoltaik = "PV") bestehen üblicherweise aus einer Lage symmetrisch angeordneter Siliziumzellen, welche in zwei Lagen einer Schutzfolie eingeschweißt werden. Diese Schutzfolie ist selbst wiederum durch ein *"backsheet"* auf ihrer Rück- und ein *"frontsheet"* auf ihrer Vorderseite stabilisiert. *"Backsheet"* und *"frontsheet"* können sowohl geeignete Kunststofffolien sein als auch aus Glas bestehen. Die Funktion des Verkapselungsmaterials besteht im Wesentlichen darin, das PV-Modul vor Witterungseinflüssen und mechanischer Belastung zu schützen, weshalb die mechanische Stabilität des jeweiligen Verkapselungsmaterials eine wichtige Eigenschaft darstellt. Daneben weisen gute Verkapselungsmaterialien eine schnelle Aushärtungsgeschwindigkeit, einen hohen Gelgehalt, eine hohe Transmission, eine geringe Neigung zu temperatur- und wärmeinduzierter Verfärbung sowie eine hohe Adhäsion (also eine geringe Neigung zur UV-induzierten Delaminierung) auf.

Die im Stand der Technik (zum Beispiel WO 2008/036708 A2) zu diesem Zweck beschriebenen Verkapselungsmaterialien beruhen typischerweise auf Materialien wie Silikonharzen, Polyvinylbutyralharzen, Ionomeren, Polyolefinfolien oder Ethylen-Vinylacetat-Copolymeren ("EVA"). Verfahren zur Herstellung solcher Verkapselungsfolien sind dem Fachmann geläufig (EP 1 164 167 A1). In diesen Verfahren werden die Vernetzer zusammen mit einem Polyolefincopolymer (und eventuell weiteren Additiven) z. B. in einem Extruder homogen vermischt und dann zu einer Folie extrudiert. Das in der EP 1 164 167 A1 beschriebene Verfahren betrifft EVA, ist aber auch auf Folien aus anderen, zum Beispiel den vorgenannten, Materialien anwendbar.

EP 0 227 470 offenbart einen transparenten Film, der hauptsächlich mit Triallylisocyanurat vernetztes Ethylen-Vinylacetat Copolymer enthält.

Die Verkapselung der Siliziumzellen erfolgt typischerweise in einem Vakuumlaminierofen (EP 2 457 728 A1). Dazu wird der Schichtaufbau des PV-Moduls vorbereitet und in einem Laminierofen (bestehend aus zwei durch eine Membran getrennte Kammern) zunächst langsam aufgeheizt. Dadurch erweicht das Polyolefincopolymer (zum Beispiel EVA). Gleichzeitig wird der Ofen evakuiert, um die Luft zwischen den Schichten zu entfernen. Dieser Schritt ist der kritischste und dauert zwischen 4 bis 6 Minuten. Im Anschluss daran wird das Vakuum über die zweite Kammer gebrochen, und über Anlegen eines Drucks werden die Schichten des Moduls miteinander verschweißt. Gleichzeitig wird bis zur Vernetzungstemperatur weiter aufgeheizt, wobei in diesem letzten Schritt dann die Vernetzung der Folie stattfindet.

Gerade EVA wird standardmäßig bei der Herstellung von Verkapselungsfolien für Solarmodule eingesetzt. Allerdings weist es auch einen geringeren spezifischen elektrischen Durchgangswiderstand p als z. B. Polyolefinfolien auf. Dies macht den Einsatz von EVA-Folien als Verkapselungsmaterial unattraktiver, da gerade Verkapselungsmaterialien mit hohem spezifischem elektrischem Durchgangswiderstand p gewünscht sind.

Bei PV-Modulen stellt nämlich der sogenannte "PID"-Effekt (PID = *"potential induced degradation")* derzeit ein großes Qualitätsproblem dar. Unter dem Begriff PID versteht man eine spannungsbedingte Leistungsdegradation, hervorgerufen durch sogenannte "Leckströme" innerhalb des PV-Moduls.

Ursache für die schädlichen Leckströme ist neben dem Aufbau der Solarzelle die Spannungslage der einzelnen PV-Module gegenüber dem Erdpotential - bei den meisten ungeerdeten PV-Systemen sind die PV-Module einer positiven oder negativen Spannung ausgesetzt. PID tritt meistens bei einer negativen Spannung gegenüber Erdpotential auf und wird durch hohe Systemspannungen, hohe Temperaturen und hohe Luftfeuchtigkeit beschleunigt. In der Folge wandern Natriumionen aus dem Deckglas des PV-Moduls an die Grenzfläche der Solarzelle und verursachen dort Schäden (*"shunt"*), die zu Leistungsverlusten und sogar zum Totalverlust des PV-Moduls führen können.

Das Risiko des Eintretens eines PID-Effektes kann durch die Erhöhung des spezifischen elektrischen Durchgangswiderstands p der Verkapselungsfolien deutlich reduziert werden.

Der spezifische elektrische Durchgangswiderstand p oder auch Resistivität *("volume resistivity",* im Folgenden auch abgekürzt als "VR") ist eine temperaturabhängige Materialkonstante. Er wird zur Berechnung des elektrischen Widerstands eines homogenen elektrischen Leiters genutzt. Der spezifische elektrische Durchgangswiderstand wird erfindungsgemäß mittels ASTM-D257 bestimmt.

Je höher der spezifische elektrische Durchgangswiderstand p eines Materials ist, desto geringer ist die Anfälligkeit von Photovoltaikmodulen gegenüber dem PID-Effekt. Eine wesentliche, positive Auswirkung bei der Steigerung des spezifischen elektrischen Durchgangswiderstands p von Verkapselungsfolien ist daher die Erhöhung der Lebensdauer und Effizienz von PV-Modulen.

Im Stand der Technik wird das Problem des PID-Effekts im Zusammenhang mit Verkapselungsfolien für PV-Module in der CN 103525321 A diskutiert. Diese Schrift beschreibt eine EVA-basierte Folie zur Verkapselung von Solarzellen, welche als Co-Vernetzer Triallylisocyanurat ("TAIC") und Trimethylolpropantrimethacrylat ("TMPTMA") sowie als weitere Additive bevorzugt ein Polyolefinionomer und ein Polysiloxan zur Hydrophobisierung enthält. Diese Folie weist einen verminderten PID-Effekt auf. Nachteilig an ihr ist allerdings, dass Polyolefinionomere relativ teuer sind. Außerdem wirken sich Polysiloxane negativ auf die Haftungseigenschaften aus. Zudem werden in den Beispielen keine spezifischen Angaben darüber gemacht, mit welchen Konzentrationen welche Verbesserungen erreicht werden können.

Eine Vernetzerkombination aus TAIC und TMPTMA beschreibt auch die JP 2007-281135 A. Das TMPTMA bewirkt hierbei eine Beschleunigung der Vernetzungsreaktion und führt damit zu einer erhöhten Produktivität.

Die JP 2012-067174 A und die JP 2012-087260 A beschreiben eine auf EVA bzw. einem Polyolefin basierende Verkapselungsfolie für Solarzellen, die neben TAIC zum Beispiel Ethylenglykoldimethacrylat, Neopentylglykoldimethacrylat, 1,6-Hexandioldimethacrylat als Vernetzer aufweist. Diese Co-Crosslinker verlangsamen die Vernetzungsreaktion am Anfang etwas und erhöhen dadurch das Verarbeitungszeitfenster.

Die JP 2009-135200 A beschreibt ebenfalls Vernetzer umfassend TAIC und verschiedene (Meth)acrylatderivate polyfunktioneller Alkohole, wobei in diesem Fall eine verbesserte Hitzebeständigkeit verbunden mit einer geringeren Tendenz zur Delamination der EVA-basierten Verkapselung beschrieben wird.

Die JP 2007-281135 A und die JP 2007-305634 A beschreiben Vernetzerkombinationen aus TAIC und Trimethylolpropantriacrylat ("TMPTA") zur Verwendung bei der Herstellung von mehrschichtigen co-extrudierten EVA-Verkapselungsfolien für Solarzellen.

Ähnliche Kombinationen von Vernetzern für Solarzellenverkapselungsfolien beschreiben z. B. die JP 2013-138094 A, JPH11-20094, JPH11-20095, JPH11-20096, JPH11-20097, JPH11-20098, JPH11-21541, CN 102391568 A, CN 102504715 A, CN 102863918 A, CN 102911612 A, CN 103045105 A, CN 103755876 A, CN 103804774 A, US 2011/0160383 A1, WO 2014/129573 A1.

Demnach besteht ein Bedürfnis hinsichtlich neuer Covernetzersysteme, insbesondere zur Herstellung von Verkapselungsfolien für Solarzellen, die im Vergleich zu Folien, die nach dem Stand der Technik vernetzt sind, zu einem deutlich erhöhten elektrischen Durchgangswiderstand führen, um so beim Einsatz in Photovoltaikmodulen zu einer Verringerung des PID-Risikos führen.

Aufgabe der vorliegenden Erfindung war es deshalb, neue Zusammensetzungen zur Verfügung zu stellen, die zur Herstellung von Folien mit möglichst hohem spezifischen elektrischen Durchgangswiderstands p verwendet werden können und sich somit besonders zur Verkapselung von elektronischen Vorrichtungen wie zum Beispiel Solarzellen eignen. Diese Zusammensetzungen sollten außerdem in den etablierten Prozessen einsetzbar sein und die Kosten der Folien nicht wesentlich erhöhen. Insbesondere sollten Sie nicht die Nachteile aufweisen, die bei den Covernetzersystemen des Standes der Technik, und hier insbesondere bei jenen in der CN 103525321 A genannten Zusammensetzungen, beobachtet werden.

Es wurde nun überraschend gefunden, dass mit Hilfe bestimmter Zusammensetzungen eine Verkapselungsfolie für Solarzellen erhalten werden kann, die diese Anforderungen erfüllt. Die hier gefundenen Zusammensetzungen erhöhen den Volumenwiderstand erheblich bei vergleichsweise kleinen Einsatzmengen, ohne andere Folieneigenschaften negativ zu beeinflussen. Die Folien haben eine exzellente Verarbeitbarkeit, eine hohe Transparenz und exzellente UV- und Wärmealterungseigenschaften.

### Detaillierte Beschreibung der Erfindung

Die Covernetzersysteme gemäß der vorliegenden Erfindung können überraschend zur Herstellung von Folien zur Verkapselung von elektronischen Vorrichtungen wie zum Beispiel Solarzellen mit einem hohen spezifischen Durchgangswiderstand verwendet werden.

Das erfindungsgemäße Covernetzersystem ist demnach eine Zusammensetzung **(Z)** umfassend (i) mindestens eine Verbindung **(I)** ausgewählt aus der Gruppe bestehend aus Triallylisocyanurat, Triallylcyanurat, wobei die Verbindung **(I)** insbesondere Triallylisocyanurat ist; und
(ii) mindestens eine Verbindung der chemischen Struktur **(II)** mit 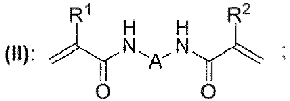 wobei
R¹, R² unabhängig voneinander jeweils Wasserstoff oder Methyl ist;
A ausgewählt ist aus der Gruppe bestehend aus unverzweigte oder verzweigte Alkylengruppe mit 1 bis 20 Kohlenstoffatomen, bei welcher mindestens ein Wasserstoffrest durch einen Halogenrest substituiert sein kann und bei welcher ein oder zwei Wasserstoffreste jeweils durch einen Rest ausgewählt aus der Gruppe bestehend aus -OR³, -C(=O)NR⁴R⁵ substituiert sein können,
Arylengruppe mit 6 bis 14 Kohlenstoffatomen, bei welcher mindestens ein Wasserstoffrest durch einen Halogenrest oder einen unverzweigten oder verzweigten Alkylrest mit 1 bis 10, bevorzugt 1 bis 8, noch bevorzugter 1 bis 6, Kohlenstoffatomen substituiert sein kann und bei welcher ein oder zwei Wasserstoffreste jeweils durch einen Rest ausgewählt aus der Gruppe bestehend aus -OR⁶, -C(=O)NR⁷R⁸ substituiert sein können,
ein verbrückender Rest der chemischen Struktur -A¹-X-A²-;
   wobei R³, R⁴, R⁵, R⁶, R⁷, R⁸ unabhängig voneinander jeweils ausgewählt aus der Gruppe bestehend aus Wasserstoff, verzweigter oder unverzweigter Alkylrest mit 1 bis 10 Kohlenstoffatome sind;
   wobei A¹, A² unabhängig voneinander jeweils eine verzweigte oder unverzweigte Alkylengruppe mit 1 bis 10 Kohlenstoffatomen ist;
   und wobei X ausgewählt aus der Gruppe bestehend aus -O-, -S-S-, -S-, -NR⁹- mit R⁹ = unverzweigter oder verzweigter Alkylrest mit 1 bis 10 Kohlenstoffatomen ist.

Eine Verbindung der chemischen Struktur **(II)** wird im Sinne der Erfindung auch als "(Meth)acrylamidverbindung" bezeichnet.

Insbesondere ist in der chemischen Struktur **(II)**
R¹, R² unabhängig voneinander jeweils Wasserstoff oder Methyl;
A ausgewählt aus der Gruppe bestehend aus
unverzweigte oder verzweigte Alkylengruppe mit 1 bis 20 Kohlenstoffatomen, Arylengruppe mit 6 bis 14 Kohlenstoffatomen, ein verbrückender Rest der chemischen Struktur -A¹-X-A²-;
   wobei A¹, A² unabhängig voneinander jeweils eine verzweigte oder unverzweigte Alkylengruppe mit 1 bis 10 Kohlenstoffatomen ist;
   und wobei X ausgewählt aus der Gruppe bestehend aus -O-, -S-S-, -S-, -NR⁹- mit R⁹ = unverzweigter oder verzweigter Alkylrest mit 1 bis 10 Kohlenstoffatomen ist.

In einer bevorzugten Ausführungsform der Zusammensetzung **(Z)** ist in der chemischen Struktur **(II)** R¹, R² unabhängig voneinander jeweils Wasserstoff oder Methyl; A ist ausgewählt aus der Gruppe bestehend aus unverzweigte oder verzweigte Alkylengruppe mit 1 bis 20 Kohlenstoffatomen, Arylengruppe mit 6 bis 14 Kohlenstoffatomen, ein verbrückender Reste der chemischen Struktur -A¹-O-A²-, wobei A¹, A² unabhängig voneinander jeweils eine verzweigte oder unverzweigte Alkylengruppe mit 1 bis 10 Kohlenstoffatomen ist.

In einer bevorzugteren Ausführungsform der Zusammensetzung **(Z)** ist in der chemischen Struktur **(II)** R¹, R² unabhängig voneinander jeweils Wasserstoff oder Methyl, insbesondere beide jeweils Wasserstoff oder beide jeweils Methyl; A ist ausgewählt aus der Gruppe bestehend aus unverzweigte oder verzweigte Alkylengruppe mit 1 bis 12 Kohlenstoffatomen, Phenylen, -(CH₂)₂-O-(CH₂)₂-, -CH₂-O-CH₂-.

In einer noch bevorzugteren Ausführungsform der Zusammensetzung **(Z)** ist in der chemischen Struktur **(II)** R¹ = R² = Wasserstoff oder R¹ = R² = Methyl; A ist ausgewählt aus der Gruppe bestehend aus unverzweigte oder verzweigte Alkylengruppe mit 1 bis 12, insbesondere 1 bis 10, bevorzugt 1 bis 8, bevorzugter 1 bis 6 Kohlenstoffatomen, -(CH₂)₂-O-(CH₂)₂-, -CH₂-O-CH₂-. Solche Verbindungen der chemischen Struktur **(II)** sind zum Beispiel *N*,*N*'-Methylendiacrylamid, *N*,*N'*-Methylendimethacrylamid, *N*,*N*'-Ethylendiacrylamid, *N*,*N*'-Hexamethylendiacrylamid, Bisacrylamiddimethylether.

In einer noch besonders bevorzugteren Ausführungsform der Zusammensetzung **(Z)** ist in der chemischen Struktur **(II)** R¹ = R² = Wasserstoff; A ist ausgewählt aus der Gruppe bestehend aus unverzweigte oder verzweigte Alkylengruppe mit 1 bis 12, insbesondere 1-bis 10, bevorzugt 1 bis 8, bevorzugter 1 bis 6 Kohlenstoffatomen, -(CH₂)₂-O-(CH₂)₂-,-CH₂-O-CH₂-.

Solche Verbindungen der chemischen Struktur **(II)** sind zum Beispiel *N*,*N*'-Methylendiacrylamid, *N*,*N*'-Ethylendiacrylamid, *N*,*N*'-Hexamethylendiacrylamid, Bisacrylamiddimethylether.

*N*,*N'*-Methylendiacrylamid ist eine Verbindung der Struktur **(II)** mit R¹ = R² = H und A = -CH₂-.

*N*,*N*'-Methylendimethacrylamid ist eine Verbindung der Struktur **(II)** mit R¹ = R² = CH₃ und A = -CH₂-.

*N*,*N*'-Ethylendiacrylamid ist eine Verbindung der Struktur **(II)** mit R¹ = R² = H und A = -CH₂-CH₂-.

*N*,*N*'-Hexamethylendiacrylamid ist eine Verbindung der Struktur **(II)** mit R¹ = R² = H und A = -(CH₂)₆-.

Bisacrylamiddimethylether ist eine Verbindung der Struktur **(II)** mit R¹ = R² = H und A = -CH₂-O-CH₂-.

Eine "Alkylengruppe" ist im Sinne der Erfindung ein zweiwertiger gesättigter Kohlenwasserstoffrest.

Eine "Arylengruppe" ist im Sinne der Erfindung ein zweiwertiger aromatischer Kohlenwasserstoffrest, zum Beispiel Naphthalen, Phenanthren, Phenylen.

"Phenylen" umfasst im Sinne der Erfindung 1,2-Phenylen, 1,3-Phenylen, 1,4-Phenylen.

Eine unverzweigte oder verzweigte Alkylengruppe mit 1 bis 6 Kohlenstoffatomen ist insbesondere ausgewählt aus Methylen, Ethylen, *n*-Propylen, *n*-Butylen, *n*-Pentylen, *n*-Hexylen. "*n*-Hexylen" ist gleichbedeutend mit "Hexamethylen".

Das Verhältnis der Menge an Verbindungen der chemischen Struktur **(II)** in der erfindungsgemäßen Zusammensetzung **(Z)** zu den Verbindungen **(I)** in der erfindungsgemäßen Zusammensetzung **(Z)** ist nicht besonders beschränkt. So ist eine Erhöhung des spezifischen Widerstandes insbesondere schon bei Zusatz geringer Mengen der Verbindungen der chemischen Struktur **(II)** feststellbar, zum Beispiel wenn in der Zusammensetzung **(Z)** der Anteil an allen Verbindungen der chemischen Struktur **(II)** bezogen auf alle Verbindungen **(I)** bei 1.0 Mol.-% liegt. Im Hinblick auf den ökonomischen Einsatz der Verbindungen der chemischen Struktur **(II)** stellt andererseits ein Anteil an allen Verbindungen der chemischen Struktur **(II)** in der Zusammensetzung **(Z)** bezogen auf alle Verbindungen **(I)** in der Zusammensetzung **(Z)** von 161.9 Mol.-% eine bevorzugte Obergrenze dar.

Bevorzugte Bereiche für den Anteil an allen Verbindungen der chemischen Struktur **(II)** in der Zusammensetzung **(Z),** bezogen auf alle Verbindungen **(I)** in der Zusammensetzung **(Z),** liegen somit im Bereich 1.0 Mol.-% bis 161.9 Mol.-%, insbesondere 2.3 Mol.-% bis 87.1 Mol.-%, bevorzugt 2.7 Mol.-% bis 53.9 Mol.-%, noch bevorzugter 3.0 Mol.-% bis 28.5 Mol.-%, bevorzugterer 3.3 Mol.-% bis 28.0 Mol.-%, noch bevorzugterer 4.6 Mol.-% bis 17.9 Mol.-%, sogar noch bevorzugter 5.6 Mol.-% bis 14.1 Mol.-%, 5.7 Mol.-% bis 10.3 Mol.-%, noch bevorzugter 6.2 Mol.-% bis 9.5 Mol.-%, noch bevorzugter 6.7 Mol.-% bis 8.8 Mol.-%, am bevorzugtesten 7.1 Mol.-% bis 8.6 Mol.-%.

In einer besonders bevorzugten Ausführungsform der erfindungsgemäßen Zusammensetzung **(Z)** umfasst diese als Verbindung **(I)** Triallylisocyanurat (= "TAIC") und als Verbindung der chemischen Struktur **(II)** *N*,*N'*-Methylendiacrylamid (= "MDAA"), wobei dann insbesondere das molare Verhältnis von MDAA zu TAIC in der Zusammensetzung **(Z)** im Bereich 1.0 Mol.-% bis 161.9 Mol.-%, bevorzugt 3.3 Mol.-% bis 87.1 Mol.-%, bevorzugter 6.7 Mol.-% bis 53.9 Mol.-%, noch bevorzugter 10.3 Mol.-% bis 28.0 Mol.-%, am bevorzugtesten 14.1 Mol.-% bis 17.9 Mol.-% liegt.

In einer weiteren besonders bevorzugten Ausführungsform der erfindungsgemäßen Zusammensetzung **(Z)** umfasst diese als Verbindung **(I)** Triallylisocyanurat ( ="TAIC") und als Verbindung der chemischen Struktur **(II)** *N*,*N*'-Ethylendiacrylamid (="EDAA"), wobei dann insbesondere das molare Verhältnis von EDAA zu TAIC in der Zusammensetzung **(Z)** im Bereich 1.0 Mol.-% bis 15.0 Mol.-%, bevorzugt 5.0 Mol.-% bis 10.0 Mol.-%, bevorzugter 6.2 Mol.-% bis 9.5 Mol.-% liegt.

In einer weiteren besonders bevorzugten Ausführungsform der erfindungsgemäßen Zusammensetzung **(Z)** umfasst diese als Verbindung **(I)** Triallylisocyanurat ( ="TAIC") und als Verbindung der chemischen Struktur **(II)** *N*,*N*'-Methylendimethacrylamid ( ="MDMAA"), wobei dann insbesondere das molare Verhältnis von MDMAA zu TAIC in der Zusammensetzung **(Z)** im Bereich 1.0 Mol.-% bis 15.0 Mol.-%, bevorzugt 5.0 Mol.-% bis 10.0 Mol.-%, bevorzugter 5.7 Mol.-% bis 8.8 Mol.-% liegt.

In einer weiteren besonders bevorzugten Ausführungsform der erfindungsgemäßen Zusammensetzung **(Z)** umfasst diese als Verbindung **(I)** Triallylisocyanurat ( ="TAIC") und als Verbindung der chemischen Struktur **(II)** *N*,*N*'-Hexyamethylendiacrylamid ( ="HDAA"), wobei dann insbesondere das molare Verhältnis von HDAA zu TAIC in der Zusammensetzung **(Z)** im Bereich 1.0 Mol.-% bis 15.0 Mol.-%, bevorzugt 2.3 Mol.-% bis 7.1 Mol.-%, bevorzugter bei 4.6 Mol.-% liegt.

In einer weiteren besonders bevorzugten Ausführungsform der erfindungsgemäßen Zusammensetzung **(Z)** umfasst diese als Verbindung **(I)** Triallylisocyanurat ( ="TAIC") und als Verbindung der chemischen Struktur **(II)** Bisacrylamiddimethylether-(="BAADME"), wobei dann insbesondere das molare Verhältnis von BAADME zu TAIC in der Zusammensetzung **(Z)** im Bereich 1.0 Mol.-% bis 15.0 Mol.-%, bevorzugt 2.7 Mol.-% bis 8.6 Mol.-%, bevorzugter bei 5.6 Mol.-% liegt.

In einer weiteren besonders bevorzugten Ausführungsform der erfindungsgemäßen Zusammensetzung **(Z)** umfasst diese als Verbindung **(I)** Triallylcyanurat (= "TAC") und als Verbindung der chemischen Struktur **(II)** *N*,*N*'-Methylendiacrylamid (= "MDAA"), wobei dann insbesondere das molare Verhältnis von MDAA zu TAC in der Zusammensetzung **(Z)** im Bereich 1.0 Mol.-% bis 161.9 Mol.-%, bevorzugt 28.5 Mol.-% bis 87.1 Mol.-%, am bevorzugtesten bei 53.9 Mol.-% liegt.

Die vorliegenden Covernetzersysteme werden bevorzugt zur Herstellung von Folien zur Verkapselung von elektronischen Vorrichtungen, z. B. Solarzellen in PV-Modulen, verwendet.

Dabei werden die Covernetzersysteme typischerweise zusammen mit Polyolefincopolymeren eingesetzt.

Die vorliegende Erfindung betrifft demnach auch eine Zusammensetzung **(B)** umfassend mindestens ein Polyolefincopolymer und die erfindungsgemäße Zusammensetzung **(Z).**

Erfindungsgemäß einsetzbare Polyolefincopolymere sind dem Fachmann bekannt und etwa in der WO 2008/036708 A2 und der JP 2012-087260 beschrieben.

Insbesondere werden erfindungsgemäß als Polyolefincopolymere Ethylen/ α-Olefin-Interpolymere eingesetzt, wobei der Begriff "Interpolymer" bedeutet, dass das betreffende Polyolefincopolymer aus mindestens zwei verschiedenen Monomeren hergestellt wurde. Somit schließt der Begriff "Interpolymer" insbesondere Polyolefincopolymere aus genau zwei Monomereinheiten, aber auch Terpolymere (zum Beispiel Ethylen/Propylen/1-Octen, Ethylen/Propylen/Buten, Ethylen/Buten/1-Octen, Ethylen/Buten/Styrol) und Tetrapolymere ein.

Als Polyolefincopolymere kommen erfindungsgemäß insbesondere Ethylen/ α-Olefin-Copolymere, die bevorzugt neben Ethylen und dem α-Olefin keine weiteren Monomereinheiten aufweisen, in Frage, wobei im Sinne der Erfindung das "α-Olefin" bevorzugt ausgewählt ist aus der Gruppe bestehend aus Propen, 1-Buten, 4-Methyl-1-Penten, 1-Hexen, 1-Octen, 1-Decen, 1-Dodecen, 1-Tetradecen, 1-Hexadecen, 1-Octadecen, 3-Cyclohexyl-1-propen, Vinylcyclohexan, Acrylsäure, Methacrylsäure, Norbornen, Styrol, Methylstyrol, Vinylacetat.

Noch bevorzugter ist das erfindungsgemäße Polyolefincopolymer in der Zusammensetzung **(B)** ein Ethylen-Vinylacetat-Copolymer.

Werden als Polyolefincopolymere Ethylen/ α-Olefin-Interpolymere eingesetzt, so weisen diese insbesondere einen α-Olefin-Gehalt im Bereich 15 bis 50 Gew.-%, bezogen auf das Gesamtgewicht des Ethylen/ α-Olefin-Interpolymers, auf. Bevorzugt liegt der α-Olefin-Gehalt im Bereich 20 bis 45 Gew.-%, bevorzugter im Bereich 25 bis 40 Gew.-%, noch bevorzugter 26 bis 34 Gew.-%, am bevorzugtesten 28 bis 33 Gew.-%, jeweils bezogen auf das Gesamtgewicht des Ethylen/ α-Olefin-Interpolymers.

In der bevorzugten Ausführungsform, in welcher es sich bei dem Polyolefincopolymer um ein Ethylen-Vinylacetat-Copolymer handelt, weist das Ethylen-Vinylacetat-Copolymer insbesondere einen Vinylacetat-Gehalt im Bereich 15 bis 50 Gew.-%, bezogen auf das Gesamtgewicht des Ethylen-Vinylacetat-Copolymers, auf. Bevorzugt liegt der Vinylacetat-Gehalt dann im Bereich 20 bis 45 Gew.-%, bevorzugter im Bereich 25 bis 40 Gew.-%, noch bevorzugter 26 bis 34 Gew.-%, am bevorzugtesten 28 bis 33 Gew.-% jeweils bezogen auf das Gesamtgewicht des Ethylen-Vinylacetat-Copolymers.

Der α-Olefin-Gehalt, insbesondere im Falle des Ethylen/ Vinylacetat-Copolymer der Gehalt an Vinylacetat, wird dabei mit dem in ASTM D 5594:1998 [*"Bestimmung des Vinylacetatgehalts von Ethylenvinylacetat(EVA)-Copolymeren mit Hilfe der Fourier-Transformations-Infrarotspektroskopie"*] beschriebenen Verfahren bestimmt.

Der Anteil der von der Zusammensetzung **(B)** umfassten Zusammensetzung **(Z)** ist dabei nicht besonders beschränkt. Der Anteil der Zusammensetzung **(Z)** in der Zusammensetzung **(B)** liegt insbesondere im Bereich von 0.05 bis 10 Gew.-%, bevorzugt im Bereich von 0.1 bis 5 Gew.-%, bevorzugter im Bereich von 0.2 bis 3 Gew.-%, noch bevorzugter bei 0.3 bis 1.5 Gew.-%, besonders bevorzugt bei 0.5 Gew-%, jeweils bezogen auf die Masse aller von der Zusammensetzung **(B)** umfassten Polyolefincopolymere.

Die Zusammensetzung **(B)** eignet sich erfindungsgemäß zur Herstellung einer Verkapselungsfolie für elektronische Vorrichtungen, zum Beispiel Solarzellen. Sie wird dazu bei der Solarmodul-Lamination einer Vernetzungsreaktion unterzogen.

Zum Start der Vernetzungsreaktion ist es üblich, Initiatoren einzusetzen, also durch Wärme, Licht, Feuchtigkeit oder Elektronenstrahlen aktivierbare Radikalbildner.

In einer bevorzugten Ausführungsform der vorliegenden Erfindung umfasst die Zusammensetzung (B) deshalb auch einen Initiator ausgewählt aus der Gruppe bestehend aus peroxidischen Verbindungen, Azoverbindungen, Photoinitiatoren. Bevorzugter ist der Initiator ausgewählt aus der Gruppe bestehend aus peroxidischen Verbindungen, Azoverbindungen. Beispiele dafür sind in der *"*Encyclopedia of Chemical Technology 1992, 3rd Edition, Vol. 17, Seiten 27- 90" beschrieben.

Peroxidische Verbindungen sind insbesondere organische Peroxide, welche wiederum ausgewählt sind aus der Gruppe bestehend aus Dialkylperoxiden, Diperoxyketalen, Peroxycarbonsäureestern, Peroxycarbonaten.

Dialkylperoxide sind insbesondere ausgewählt aus der Gruppe bestehend aus Dicumylperoxid, Di-*tert*-butylperoxid, Di-*tert*-Hexylperoxid, *tert*-Butylcumylperoxid, *iso*-Propylcumyl-*tert*-butylperoxid, *tert*-Hexylcumylperoxid, 2,5-Dimethyl-2,5-di(*tert*-butylperoxy)-hexan, 2,5-Dimethyl-2,5-di(*tert*-amylperoxy)-hexan, 2,5-Dimethyl-2,5-di(*tert*-butylperoxy)-hex-3-in, 2,5-Dimethyl-2,5-di(*tert*-amylperoxy)-hex-3-in, α,α-Di[(*tert*-butylperoxy)-*iso*-propyl]-benzol, Di-*tert*-amylperoxid, 1,3,5-Tri-[(*tert*-butylperoxy)-isopropyl]-benzol, 1,3-Dimethyl-3-(*tert*-butylperoxy)-butanol, 1,3-dimethyl-3-(*tert*-amylperoxy)-butanol, *iso*-Propylcumylhydroperoxid.

Diperoxyketale sind insbesondere ausgewählt aus der Gruppe bestehend aus 1,1-Di(*tert*-butylperoxy)-3,3,5-trimethylcyclohexan, 1,1-Di(*tert*-amylperoxy)-cyclohexan, 1,1-Di(*tert*-butylperoxy)-cyclohexan, *n*-Butyl-4,4-di(*tert*-amylperoxy)-valerat, Ethyl-3,3-di(*tert*-butylperoxy)-butyrat, 2,2-Di(*tert*-butylperoxy)butan, 3,6,6,9,9-Pentamethyl-3-ethoxycarbonylmethyl-1,2,4,5-tetraoxacyclononan, 2,2-Di(*tert*-amylperoxy)-propan, *n*-Butyl-4,4-bis(*tert*-butylperoxy)-valerat.

Peroxycarbonsäureester sind insbesondere ausgewählt aus der Gruppe bestehend aus *tert*-Amylperoxyacetat, *tert*-Butylperoxy-3,5,5-trimethylhexanoat, *tert*-Amylperoxybenzoat, *tert*-Butylperoxyacetat, *tert*-Butylperoxybenzoat, OO*-tert-*Butylmonoperoxysuccinat, OO-*tert*-Amylmonoperoxysuccinat.

Peroxycarbonate sind insbesondere ausgewählt aus der Gruppe bestehend aus *tert*-Butylperoxy-2-ethylhexylcarbonat, *tert*-Butylperoxy-*iso*-propylcarbonat, *tert*-Amylperoxy-2-ethylhexyl-carbonat, *tert*-Amylperoxybenzoat. Ein bevorzugtes Peroxycarbonat ist *tert*-Butylperoxy-2-ethylhexylcarbonat ("TBPEHC").

Die Azoverbindung ist bevorzugt ausgewählt aus der Gruppe bestehend aus 2,2'-Azobis-(2-acetoxypropan), 1,1'-Azodi(hexahydrobenzonitril).

Besonders bevorzugt ist der Initiator ausgewählt aus der Gruppe bestehend aus 2,5-Dimethyl-2,5-di(*tert*-butylperoxy)-hexan, *tert*-Butylperoxy-2-ethylhexylcarbonat, *tert*-Butylperoxy-3,5,5-trimethylhexanoat, 1,1-Di(*tert*-butylperoxy)-3,5,5-trimethylcyclohexan, *tert*-Amylperoxy-2-ethylhexylcarbonat; am bevorzugtesten ist der Initiator *tert*-Butylperoxy-2-ethylhexylcarbonat ("TBPEHC").

Die Masse der peroxidischen Verbindung oder der Azoverbindung, bevorzugt der peroxidischen Verbindung, welche bezogen auf die Masse des Polyolefincopolymers eingesetzt wird, ist nicht besonders beschränkt. Die peroxidische Verbindung oder die Azoverbindung, bevorzugt die peroxidische Verbindung, wird insbesondere in einer Menge von 0.05 bis 10 Gew.-%, bevorzugt 0.1 bis 5 Gew.-%, bevorzugter 0.5 bis 2 Gew.-%, jeweils bezogen auf die Masse aller von der Zusammensetzung **(B)** umfassten Polyolefincopolymere, eingesetzt.

Photoinitiatoren sind insbesondere ausgewählt aus der Gruppe bestehend aus Benzophenon, Benzanthron, Benzoin, Benzoinalkylether, 2,2-Diethoxyacetophenon, 2,2-Dimethoxy-2-phenylacetophenon, *p*-Phenoxydichloracetophenon, 2-Hydroxycyclohexylphenon, 2-Hydroxyisopropylphenon, 1-Phenylpropandion-2-(ethoxycarbonyl)-oxim.

Der Photoinitiator wird insbesondere in einer Menge von 0.05 bis 10 Gew.-%, bevorzugt 0.1 bis 5 Gew.-%, bevorzugter 0.2 bis 3 Gew.-%, noch bevorzugter 0.25 bis 1 Gew.-%, jeweils bezogen auf die Masse aller von der Zusammensetzung **(B)** umfassten Polyolefincopolymere, eingesetzt.

In einer weiteren bevorzugten Ausführungsform der vorliegenden Erfindung umfasst die Zusammensetzung **(B)** auch mindestens eine weitere Verbindung ausgewählt aus der Gruppe bestehend aus Vernetzern, Silankupplungsmitteln, Antioxidantien, Alterungsschutzmittel, Metalloxiden, Metallhydroxiden, Weißpigmenten; wobei als weitere Verbindung besonders bevorzugt Silankupplungsmittel eingesetzt werden.

Der Begriff "weitere Verbindung" impliziert dabei im Sinne der Erfindung, dass es sich bei dieser Verbindung nicht um Triallylisocyanurat, Triallylcyanurat oder eine Verbindung der chemischen Struktur **(II)** handelt.

Vernetzer sind dabei bevorzugt ausgewählt aus der Gruppe bestehend aus Trimethylolpropantriacrylat, Trimethylolpropantrimethacrylat, Divinylbenzol, Acrylate und Methacrylate von polyhydrischen Alkoholen. Acrylate und Methacrylate von polyhydrischen Alkoholen sind insbesondere ausgewählt aus der Gruppe bestehend aus Ethylenglycoldi(meth)acrylat, Diethylenglycoldi(meth)acrylat, Polyethylenglycoldi(meth)acrylat, Neopentylglycoldi(meth)acrylat, 1,6-Hexandioldi(meth)acrylat, 1,9-Nonandioldi(meth)acrylat, 1,10-Decandioldi(meth)acrylat.

Der Anteil der von der Zusammensetzung **(B)** umfassten Vernetzer ist dabei nicht besonders beschränkt. Der Anteil der Vernetzer in der Zusammensetzung **(B)** liegt insbesondere bei 0.005 bis 5 Gew.-%, bevorzugt 0.01 bis 3 Gew.-%, bevorzugter 0.05 bis 3 Gew.-%, noch bevorzugter 0.1 bis 1.5 Gew.-%, jeweils bezogen auf die Masse aller von der Zusammensetzung **(B)** umfassten Polyolefincopolymere.

Als erfindungsgemäß in der Zusammensetzung **(B)** einsetzbare Silankupplungsmittel kommen alle Silane in Betracht, welche einen ungesättigten Kohlenwasserstoffrest und einen hydrolysierbaren Rest aufweisen (beschrieben etwa in EP 2 436 701 B1, US 5,266,627).

Ungesättigte Kohlenwasserstoffreste sind insbesondere ausgewählt aus der Gruppe bestehend aus Vinyl, Allyl, Isopropenyl, Butenyl, Cyclohexenyl, γ-(Meth)acryloxyallyl.

Hydrolisierbarer Reste sind insbesondere ausgewählt aus der Gruppe bestehend aus Hydrocarbyloxy, Hydrocarbonyloxy, Hydrocarbylamino. Bevorzugt ist der hydrolysierbare Rest ausgewählt aus der Gruppe bestehend aus Methoxy, Ethoxy, Formyloxy, Acetoxy, Proprionyloxy, Alkylamino, Arylamino.

Bevorzugt ist das Silankupplungsmittel ausgewählt aus der Gruppe bestehend aus: Vinyltriethoxysilan, Vinyltris-(β-methoxyethoxy)silan, Vinyltriacetoxysilan, γ-Acryloxypropyltrimethoxysilan, γ-Methacryloxypropyltrimethoxysilan, *N*-(β-aminoethyl)-γ-aminopropyltrimethoxysilan, *N*-(β-Aminoethyl)-γ-aminopropylmethyldimethoxysilan, γ-Aminopropyltriethoxysilan, γ-Glycidoxypropyltrimethoxysilan, γ-Mercaptopropyltriethoxysilan, γ-Chlorpropyltrimetoxysilan, β-(3,4-Ethoxycyclohexyl)-ethyltrimethoxysilan, γ-Mercaptopropyltrimethoxysilan. Besonders bevorzugt wird als Silankupplungsmittel γ-Methacryloxypropyltrimethoxysilan (abgekürzt als "KBM") eingesetzt.

Der Anteil des von der Zusammensetzung **(B)** umfassten Silankupplungsmittels ist dabei nicht besonders beschränkt. Der Anteil aller von der Zusammensetzung **(B)** umfassten Silankupplungsmittel liegt insbesondere bei 0.05 bis 5 Gew.-%, bevorzugt 0.1 bis 2 Gew.-%, jeweils bezogen auf die Masse aller von der Zusammensetzung **(B)** umfassten Polyolefincopolymere.

Antioxidantien sind im Sinne der Erfindung bevorzugt ausgewählt aus der Gruppe bestehend aus phenolischen Antioxidantien, phosphorhaltigen Antioxidantien.

Phenolische Antioxidantien sind insbesondere ausgewählt aus der Gruppe bestehend aus 4-Methoxyphenol, 2,6-Di-*tert*-butyl-4-methylphenol, *tert*-Butylhydrochinon, Stearyl-β-(3,5-di-*tert*-butyl-4-hydroxyphenyl)-propionat, Pentaerythrittetrakis-[3-(3,5-di-*tert*-butyl-4-hydroxyphenyl)-propionat], 3,5-Di-*tert*-butyl-4-hydroxybenzoësäurehexadecylester.

Phosphorhaltige Antioxidantien sind insbesondere ausgewählt aus der Gruppe bestehend aus Triphenylphosphit, Tris-(nonylphenyl)-phosphit, Distearylpentaerythritoldiphosphit, Tetra-(tridecyl)-1,1,3-tris-(2-methyl-5-*tert*-butyl-4-hydroxyphenyl)-butan-diphosphat, Tetrakis-(2,4-di-*tert*-butylphenyl)-4,4-biphenyldiphosphonit.

Der Anteil der von der Zusammensetzung **(B)** umfassten Antioxidantien ist dabei nicht besonders beschränkt. Der Anteil aller von der Zusammensetzung **(B)** umfassten Antioxidantien liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

Alterungsschutzmittel sind im Sinne der Erfindung insbesondere ausgewählt aus der Gruppe der"*hindered amine light stabilizers*" (= "HALS")-Stabilisatoren und der UV-Absorber.

HALS-Stabilisatoren sind im Sinne der Erfindung insbesondere Verbindungen, die mindestens einen 2,2,6,6-Tetramethyl-4-piperidyl-Rest aufweisen, wobei das Stickstoffatom an der 1-Position des Piperidylrestes ein H, eine Alkylgruppe oder eine Alkoxygruppe trägt.

Bevorzugt sind HALS-Stabilisatoren ausgewählt aus der Gruppe bestehend aus Bis(2,2,6,6-tetramethyl-4-piperidyl)-sebacat, 1,2,2,6,6-Pentamethyl-4-piperidylsebacat, Bis(1,2,2,6,6-pentamethyl-4-piperidyl)-sebacat, Bis-(1-octyloxy-2,2,6,6-tetramethyl-4-piperidyl)-sebacat, Poly-{(6-morpholino-S-triazin-2,4-diyl)-[2,2,6,6-tetramethyl-4-piperidyl)-imino]- hexamethylen-[(2,2,6 ,6-tetramethyl-4-piperidyl)-imino]} mit der CAS-Nummer 82451-48-7, Polymere der CAS-Nummer 193098-40-7, Copolymer aus Dimethylsuccinat und 1-(2-Hydroxyethyl)-2,2,6,6-tetramentyl-4-piperidinol, *N*,*N*',*N*",*N*"'-Tetrakis-{4,6-bis-[butyl-(*N*-methyl-2,2,6,6-tetramethylpiperidin-4-yl)-amino]-triazin-2-yl}-4,7-diazadecan-1,10-diamin mit der CAS-Nummer 106990-43-6.

Der Anteil der von der Zusammensetzung **(B)** umfassten HALS-Stabilisatoren ist dabei nicht besonders beschränkt. Der Anteil aller von der Zusammensetzung **(B)** umfassten HALS-Stabilisatoren liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

UV-Absorber sind insbesondere ausgewählt aus der Gruppe bestehend aus 2-Hydroxy-4-*N*-octoxybenzophenon, 2,4-Di-*tert*-butylphenyl-3,5-di-*tert*-butyl-4-hydroxybenzoat, 2-Hydroxy-4-methoxybenzophenon, 2,2-Dihydroxy-4-methoxybenzophenon, 2-Hydroxy-4-methoxy-4-carboxybenzophenon, 2-(2-Hydroxy-3,5-di-*tert*-butylphenyl)-benzotriazol, 2-(2-Hydroxy-5-methylphenyl)-benzotriazol, p-Octyl-phenyl salicylat, 2-(4,6-Diphenyl-1,3,5-triazine-2-yl)-5-[(hexyl)-oxy]-phenol, Ethyl-2-cyano-3,3-diphenyl-acrylat.

Der Anteil der von der Zusammensetzung **(B)** umfassten UV-Absorber ist dabei nicht besonders beschränkt. Der Anteil aller von der Zusammensetzung **(B)** umfassten UV-Absorber liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

Metalloxide sind erfindungsgemäß insbesondere ausgewählt aus der Gruppe bestehend aus Alkalimetalloxiden, Erdalkalimetalloxiden, Zinkoxid, bevorzugt ausgewählt aus der Gruppe bestehend aus Magnesiumoxid, Zinkoxid.

Der Anteil der von der Zusammensetzung **(B)** umfassten Metalloxide ist dabei nicht besonders beschränkt. Der Anteil aller von der Zusammensetzung **(B)** umfassten Metalloxide liegt insbesondere bei 0.01 bis 10 Gew.-%, bevorzugt 0.05 bis 3 Gew.-%, jeweils bezogen auf die Masse aller von der Zusammensetzung **(B)** umfassten Polyolefincopolymere.

Metallhydroxide sind erfindungsgemäß insbesondere ausgewählt aus der Gruppe bestehend aus Alkalimetallhydroxiden, Erdalkalimetallhydroxiden, bevorzugt ausgewählt aus der Gruppe bestehend aus Magnesiumhydroxid, Calciumhydroxid.

Der Anteil der von der Zusammensetzung **(B)** umfassten Metallhydroxide ist dabei nicht besonders beschränkt. Der Anteil aller von der Zusammensetzung **(B)** umfassten Metallhydroxide liegt insbesondere bei 0.01 bis 10 Gew.-%, bevorzugt 0.05 bis 3 Gew.-%, jeweils bezogen auf die Masse aller von der Zusammensetzung **(B)** umfassten Polyolefincopolymere.

Weißpigmente sind im Sinne der Erfindung insbesondere ausgewählt aus der Gruppe Titandioxid, Zinkoxid, Zinksulfid, Bariumsulfat, Lithopone.

Der Anteil der von der Zusammensetzung **(B)** umfassten Weißpigmente ist dabei nicht besonders beschränkt. Der Anteil aller von der Zusammensetzung **(B)** Weißpigmente liegt insbesondere bei 5 bis 25 Gew.-%, bevorzugt 10 bis 20 Gew.-%, noch bevorzugter bei 15 Gew.-%, jeweils bezogen auf die Masse aller von der Zusammensetzung **(B)** umfassten Polyolefincopolymere.

Die Polymerzusammensetzung **(B)** wird in einem weiteren Aspekt der vorliegenden Erfindung zur Herstellung einer Folie zur Verkapselung einer elektronischen Vorrichtung, insbesondere einer Solarzelle, verwendet.

Dabei wird die Zusammensetzung **(B)** zunächst durch Mischen der Zusammensetzung **(Z)** sowie den jeweiligen Additiven und dem Polyolefincopolymer hergestellt. Dies erfolgt insbesondere durch Zugabe der Additive in flüssiger Form, d.h. rein oder als Lösung in einem Lösungsmittel, zu der Zusammensetzung **(B)** in einem Mischer. Danach wird so lange gerührt oder die Mischung in Bewegung gehalten, bis die Flüssigkeit vollständig vom Polymergranulat absorbiert worden ist. Eventuell verwendete Lösemittel werden dann wieder durch Anlegen eines Vakuums entfernt.

In einem zweiten Schritt wird die Polymerformulierung über einen Extruder zu einem Film extrudiert. Hierbei wird die Zusammensetzung **(B)** kontinuierlich über eine Dosierschnecke in einen Extruder dosiert in dem das Poymer aufschmilzt und die Additive durch das Kneten der Mischung homogen in der Polymermatrix verteilt werden. Am Ende des Extruders wird die Schmelze durch eine Breitschlitzdüse gepresst. Nach der Düse wird die Folie durch ein Walzwerk abgezogen, nachgekühlt und aufgewickelt.

Alternativ können die Additive oder die Additivmischung auch direkt über den Einfüllstutzen oder über eine Seitendosierung in den Filmextruder dosiert werden.

Die nachfolgenden Beispiele sollen die vorliegende Erfindung weiter erläutern, ohne dass diese auf diese Beispiele beschränkt sein soll.

### Beispiele

### Verwendete Abkürzungen

*N*,*N*'-Methylendiacrylamid = MDAA;
*N*,*N*'-Methylendimethacrylamid = MDMAA;
*N*,*N*'-Ethylendiacrylamid = EDAA;
*N*,*N*'-Hexamethylendiacrylamid = HDAA;
Bisacrylamiddimethylether = BAADME;
γ-Methacryloxypropyltrimethoxysilan = KBM;
Triallylcyanurat = TAC;
Triallylisocyanurat = TAIC.

### Verwendete Chemikalien

*N*,*N'*-Methylendiacrylamid wurde bezogen von Merck.

*N*,*N'*-Methylendimethacrylamid wurde bezogen von Abcr GmbH & Co.

*N*,*N'*-Ethylendiacrylamid wurde bezogen von Abcr GmbH & Co.

*N*,*N*'-Hexamethylendiacrylamid wurde bezogen von Abcr GmbH & Co.

Bisacrylamiddimethylether wurde bezogen von Abcr GmbH & Co.

Bei dem im Folgenden verwendeten Triallylisocyanurat handelte es sich um "TAICROS ®" der Evonik Industries AG.

Bei dem im Folgenden verwendeten Triallylcyanurat handelte es sich um "TAC" der Evonik Industries AG.

Bei dem im Folgenden verwendeten γ-Methacryloxypropyltrimethoxysilan handelte es sich um "Dynasylan Memo ®" der Evonik Industries AG.

Bei dem im Folgenden verwendeten EVA handelte es sich um "EVATANE 28-40" ® von Arkema mit einem Gehalt an Vinylacetat von 28.3 Gew.-%.

Das im Folgenden verwendete *tert*-Butylperoxy-2-ethylhexylcarbonat (="TBPEHC") wurde von der Firma United Initiators erworben.

### 1. Herstellung des EVA-Granulats

### Vergleichsbeispiel V1

2.5 g (10.0 mmol) TAIC, 0.5 g KBM und 4.0 g TBPEHC wurden homogen vermischt. Diese Mischung wurde auf 493 g EVA gleichmäßig verteilt. Die EVA-Additivmischung wurde anschließend für 2 bis 4 h in einem Taumelmischer durchmischt.

### Erfindungsgemäße Beispiele 1 bis 19

### Beispiel 1

0.052 g (0.34 mmol) MDAA wurden in einer Mischung aus 2.54 g (10.2 mmol) TAIC, 0.52 g KBM, 4.15 g TBPEHC und 1.73 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 2

0.104 g (0.67 mmol) MDAA wurden in einer Mischung aus 2.5 g (10.0 mmol) TAIC, 0.52 g KBM, 4.15 g TBPEHC und 1.73 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 3

0.16 g (1.01 mmol) MDAA wurden in einer Mischung aus 2.44 g (9.78 mmol) TAIC, 0.52 g KBM, 4.15 g TBPEHC und 1.73 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 4

0.208 g (1.35 mmol) MDAA wurden in einer Mischung aus 2.39 g (9.58 mmol) TAIC, 0.52 g KBM, 4.15 g TBPEHC und 1.73 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 5

0.26 g (1.68 mmol) MDAA wurden in einer Mischung aus 2.34 g (9.37 mmol) TAIC, 0.52 g KBM, 4.15 g TBPEHC und 1.73 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 6

0.408 g (2.6 mmol) MDAA wurden in einer Mischung aus 2.31 g (9.27 mmol) TAIC, 0.543 g KBM, 4.347 g TBPEHC und 2.0 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 7

0.625 g (4.05 mmol) MDAA wurden in einer Mischung aus 1.875 g (7.52 mmol) TAIC, 0.5 g KBM, 4.0 g TBPEHC und 3.0 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 8

0.86 g (5.59 mmol) MDAA wurden in einer Mischung aus 1.6 g (6.42 mmol) TAIC, 0.5 g KBM, 3.94 g TBPEHC und 4.1 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 9

1.25 g (8.11 mmol) MDAA wurden in einer Mischung aus 1.25 g (5.01 mmol) TAIC, 0.5 g KBM, 4.0 g TBPEHC und 6.0 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 10

0.1 g (0.62 mmol) EDAA wurden in einer Mischung aus 2.5 g (10 mmol) TAIC, 0.52 g KBM, 4.15 g TBPEHC und 1.73 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 11

0.15 g (0.93 mmol) EDAA wurden in einer Mischung aus 2.44 g (9.79 mmol) TAIC, 0.52 g KBM, 4.15 g TBPEHC und 1.73 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 12

0.1 g (0.57 mmol) MDMAA wurden in einer Mischung aus 2.5 g (10 mmol) TAIC, 0.52 g KBM, 4.15 g TBPEHC und 1.73 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 13

0.16 g (0.85 mmol) MDMAA wurden in einer Mischung aus 2.44 g (9.79 mmol) TAIC, 0.52 g KBM, 4.15 g TBPEHC und 1.73 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 14

0.05 g (0.23 mmol) HDAA wurden in einer Mischung aus 2.54 g (10.2 mmol) TAIC, 0.52 g KBM, 4.15 g TBPEHC und 1.73 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 15

0.10 g (0.46 mmol) HDAA wurden in einer Mischung aus 2.5 g (10.0 mmol) TAIC, 0.52 g KBM, 4.15 g TBPEHC und 1.73 g Methanol gelöst. Diese Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 16

0.16 g (0.69 mmol) HDAA wurden in einer Mischung aus 2.44 g (9.78 mmol) TAIC, 0.52 g KBM, 4.15 g TBPEHC und 1.73 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 17

0.05 g (0.27 mmol) BAADME wurden in einer Mischung aus 2.45 g (9.83 mmol) TAIC, 0.5 g KBM, 4.0 g TBPEHC und 0.25 g Methanol gelöst. Diese Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 18

0.1 g (0.54 mmol) BAADME wurden in einer Mischung aus 2.4 g (9.63 mmol) TAIC, 0.5 g KBM, 4.0 g TBPEHC und 0.75 g Methanol gelöst. Diese Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel 19

0.15 g (0.81 mmol) BAADME wurden in einer Mischung aus 2.35 g (9.43 mmol) TAIC, 0.5 g KBM, 4.0 g TBPEHC und 1.25 g Methanol gelöst. Diese Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Vergleichsbeispiel V2

2.5 g (10 mmol) Triallylcyanurat (="TAC") wurden mit 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 20

2.13 g (8.52 mmol) TAC wurden zusammen mit 0.375 g (2.43 mmol) MDAA, gelöst in 3.5 g Methanol, 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 21

1.875 g (7.52 mmol) TAC wurden zusammen mit 0.625 g (4.05 mmol) MDAA, gelöst in 4.7 g Methanol, 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### Beispiel 22

1.625 g (6.52 mmol) TAC wurden zusammen mit 0.875 g (5.68mmol) MDAA, gelöst in 7.4 g Methanol, 0.5 g KBM und 4.0 g TBPEHC homogen vermischt. Die Mischung wurde auf 493 g EVA gleichmäßig verteilt und die so erhaltene Additivmischung anschließend für 2 bis 4 Stunden in einem Taumelmischer durchmischt.

### 2. Folienextrusion

Zur Herstellung der EVA-Folien wurde das konditionierte EVA-Granulat, welches wie in den Beispielen V1, V2, 1 - 22 beschrieben hergestellt worden war, volumetrisch in einem Doppelschnecken-Laborextruder (Collin) dosiert. Die EVA Schmelze wurde über eine Breitschlitzdüse (10 cm) mit einstellbarer Spaltdicke verdüst, die Folie kontinuierlich auf einem Walzwerk auf 20 °C mit Wasser nachgekühlt und anschließend aufgewickelt. Die Extrudereinstellungen sind nachstehend aufgeführt:
Extrusionsparameter für EVA-Folienherstellung

| Temperatur Heizzonen [°C] | |
|---|---|
| T1 | 70 |
| T2 | 77 |
| T3 | 77 |
| T4 | 75 |
| T5 | 80 |
| Düse | 80 |

### 3. Folienlamination

Die Lamination der EVA-Folie wurde bei 150 °C (Maschineneinstellung) zwischen Teflontrennfolien durchgeführt, wobei die entsprechende Temperatur über den gesamten Laminationsprozess konstant gehalten wurde. Die Dauer des einstufigen Entgasungsschrittes betrug 100 s. Anschließend wurde die Probe mit einem Anpressdruck von 0.7 kg/cm² verpresst. Die Verweilzeit im Laminator betrug 20 Minuten.

### 4. Bestimmung des spezifischen Widerstands ρ

Für die Bestimmung des Widerstandes von vernetzten, 400 bis 500 µm starken EVA Folien wurden zunächst Proben mit den Abmaßen ca. 8 x 8 cm bei Raumtemperatur (22.5 °C) und einer relativen Luftfeuchte von 50 % für 7 Tage gelagert, um ein konstantes Feuchtigkeitslevel innerhalb des EVA Films zu gewährleisten.

Die Widerstandsmessung wurde mit einem Ohmmeter der Firma Keithley (6517B) und einer entsprechenden Messzelle, ebenfalls von Keithley ("*resistivity test fixture 8009*"), durchgeführt. Nach ASTM D-257 wurde die Probe mit einer Spannung von 500 V für 60 s beaufschlagt und nach dieser Zeit der Strom gemessen. Der Widerstand p (VR) lässt sich dann aus den bekannten Größen berechnen.

### 5. Ergebnisse der Widerstandsmessungen der Beispielformulierungen

### 5.1 Vergleichsbeispiel V1, erfindungsgemäße Beispiele 1 bis 9

Die nachfolgende Tabelle 1 gibt die VR-Werte an, die mit dem gemäß Vergleichsbeispiel V1 erhaltenen EVA-Granulat und den gemäß erfindungsgemäßen Beispielen 1 bis 9 erhaltenen EVA-Granulaten hergestellten Folien gemessen wurden. Das Covernetzersystem umfasste dabei TAIC und MDAA in den in Tabelle 1 angegebenen Mengen.

**Tabelle 1:**

| Beispiel Nr. | TAIC [mmol] | MDAA [mmol] | Anteil MDAA bezogen auf TAIC in mol.-% | VR * 10¹⁵ [Ohm*cm] |
|---|---|---|---|---|
| V1 | 10 | 0 | 0 | 3.77 |
| 1 | 10.2 | 0.34 | 3.3 | 5.69 |
| 2 | 10.0 | 0.67 | 6.7 | 8.67 |
| 3 | 9.78 | 1.01 | 10.3 | 11.1 |
| 4 | 9.58 | 1.35 | 14.1 | 15.72 |
| 5 | 9.37 | 1.68 | 17.9 | 18.32 |
| 6 | 9.27 | 2.6 | 28.0 | 44 |
| 7 | 7.52 | 4.05 | 53.9 | 86.46 |
| 8 | 6.42 | 5.59 | 87.1 | 30.12 |
| 9 | 5.01 | 8.11 | 161.9 | 33.07 |

### 5.2 Erfindungsgemäße Beispiele 10 bis 19

Die nachfolgende Tabelle 2 gibt die VR-Werte an, die mit den gemäß erfindungsgemäßen Beispielen 11 bis 19 erhaltenen EVA-Granulaten hergestellten Folien gemessen wurden. Das Covernetzersystem umfasste dabei TAIC und den jeweils in der Tabelle 2 angegebenen Co-Crosslinker in den in Tabelle 2 jeweils angegebenen Mengen.

**Tabelle 2:**

| Beispiel Nr. | TAIC [mmol] | Co-crosslinker | Co-crosslinker [mmol] | Anteil Co-Crosslinker bezogen auf TAIC [mol.-%] | VR * 10¹⁵ [Ohm*cm] |
|---|---|---|---|---|---|
| 10 | 10.0 | EDAA | 0.62 | 6.2 | 4.86 |
| 11 | 9.79 | EDAA | 0.93 | 9.5 | 9.24 |
| 12 | 10.0 | MDMAA | 0.57 | 5.7 | 4.98 |
| 13 | 9.79 | MDMAA | 0.85 | 8.8 | 5.51 |
| 14 | 10.2 | HDAA | 0.23 | 2.3 | 4.50 |
| 15 | 10.0 | HDAA | 0.46 | 4.6 | 6.37 |
| 16 | 9.78 | HDAA | 0.69 | 7.1 | 7.40 |
| 17 | 9.83 | BAADME | 0.27 | 2.7 | 5.80 |
| 18 | 9.63 | BAADME | 0.54 | 5.6 | 7.12 |
| 19 | 9.43 | BAADME | 0.81 | 8.6 | 13.27 |

### 5.3 Vergleichsbeispiel V2, erfindungsgemäße Beispiele 20 bis 22

Die nachfolgende Tabelle 3 gibt die VR-Werte an, die mit dem gemäß Vergleichsbeispiel V2 erhaltenen EVA-Granulat und den gemäß erfindungsgemäßen Beispielen 20 bis 22 erhaltenen EVA-Granulaten hergestellten Folien gemessen wurden. Das Covernetzersystem umfasste dabei TAC und MDAA in den in Tabelle 3 jeweils angegebenen Mengen.

**Tabelle 3:**

| Beispiel Nr. | TAC [mmol] | MDAA [mmol] | Anteil MDAA bez. auf TAC in mol.-% | VR * 10¹⁵ [Ohm*cm] |
|---|---|---|---|---|
| V2 | 10.0 | 0 | 0 | 4.2 |
| 20 | 8.52 | 2.43 | 28.5 | 64.05 |
| 21 | 7.52 | 4.05 | 53.9 | 79.22 |
| 22 | 6.52 | 5.68 | 87.1 | 74.03 |

Die in den Tabellen 1 bis 3 dargestellten Ergebnisse belegen, dass die Kombination aus TAIC bzw. TAC und verschiedenen (Meth-)acrylamidverbindungen eine deutliche Erhöhung des spezifischen Widerstandes ergibt. Der so erhaltene spezifische Widerstand ist sogar höher als der mit herkömmlichen Co-Vernetzern erreichte.

## Patentansprüche

1. Zusammensetzung **(Z)** umfassend
(i) mindestens eine Verbindung **(I)** ausgewählt aus der Gruppe bestehend aus Triallylisocyanurat, Triallylcyanurat; und
(ii) mindestens eine Verbindung der chemischen Struktur **(II)** mit 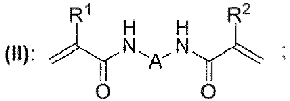 wobei
R¹, R² unabhängig voneinander jeweils Wasserstoff oder Methyl ist;
A ausgewählt ist aus der Gruppe bestehend aus
unverzweigte oder verzweigte Alkylengruppe mit 1 bis 20 Kohlenstoffatomen, bei welcher mindestens ein Wasserstoffrest durch einen Halogenrest substituiert sein kann und bei welcher ein oder zwei Wasserstoffreste jeweils durch einen Rest ausgewählt aus der Gruppe bestehend aus -OR³, -C(=O)NR⁴R⁵ substituiert sein können,
Arylengruppe mit 6 bis 14 Kohlenstoffatomen, bei welcher mindestens ein Wasserstoffrest durch einen Halogenrest oder einen unverzweigten oder verzweigten Alkylrest mit 1 bis 10 Kohlenstoffatomen substituiert sein kann und bei welcher ein oder zwei Wasserstoffreste jeweils durch einen Rest ausgewählt aus der Gruppe bestehend aus -OR⁶, -C(=O)NR⁷R⁸ substituiert sein können,
ein verbrückender Rest der chemischen Struktur -A¹-X-A²-;
wobei R³, R⁴, R⁵, R⁶, R⁷, R⁸ unabhängig voneinander jeweils ausgewählt aus der Gruppe bestehend aus Wasserstoff, verzweigter oder unverzweigter Alkylrest mit 1 bis 10 Kohlenstoffatome sind;
wobei A¹, A² unabhängig voneinander jeweils eine verzweigte oder unverzweigte Alkylengruppe mit 1 bis 10 Kohlenstoffatomen ist;
und wobei X ausgewählt aus der Gruppe bestehend aus -O-, -S-S-, -S-, -NR⁹- mit R⁹ = unverzweigter oder verzweigter Alkylrest mit 1 bis 10 Kohlenstoffatomen ist.

2. Zusammensetzung **(Z)** nach Anspruch 1, wobei die Verbindung **(I)** Triallylisocyanurat ist.

3. Zusammensetzung **(Z)** nach Anspruch 1 oder 2, wobei R¹, R² unabhängig voneinander jeweils Wasserstoff oder Methyl ist und wobei A ausgewählt ist aus der Gruppe bestehend aus unverzweigte oder verzweigte Alkylengruppe mit 1 bis 12 Kohlenstoffatomen,
Phenylen, -(CH₂)₂-O-(CH₂)₂-, -CH₂-O-CH₂-.

4. Zusammensetzung **(Z)** nach Anspruch 3, wobei R¹ = R² = Wasserstoff und A = -CH₂-.

5. Zusammensetzung **(Z)** nach einem der Ansprüche 1 bis 4, worin der Anteil an allen Verbindungen der chemischen Struktur **(II)** bezogen auf alle Verbindungen **(I)** im Bereich 1.0 bis 161.9 Mol.-% liegt.

6. Zusammensetzung **(B)** umfassend mindestens ein Polyolefincopolymer und eine Zusammensetzung **(Z)** nach einem der Ansprüche 1 bis 5.

7. Zusammensetzung **(B)** nach Anspruch 6, wobei das Polyolefincopolymer ein Ethylen-Vinylacetat-Copolymer ist.

8. Zusammensetzung **(B)** nach Anspruch 7, wobei das Ethylen-Vinylacetat-Copolymer einen Vinylacetatgehalt von 15 bis 50 Gew.-%, bezogen auf das Gesamtgewicht des Ethylen-Vinylacetat-Copolymers, bestimmt nach ASTM D 5594:1998, aufweist.

9. Zusammensetzung **(B)** nach einem der Ansprüche 6 bis 8, worin der Anteil an Zusammensetzung **(Z)** bei 0.05 bis 10 Gew.-%, bezogen auf die Masse aller von der Zusammensetzung **(B)** umfassten Polyolefincopolymere, liegt.

10. Zusammensetzung **(B)** nach einem der Ansprüche 6 bis 9, welche zusätzlich mindestens einen Initiator ausgewählt aus der Gruppe bestehend aus peroxidischen Verbindungen, Azoverbindungen, Photoinitiatoren umfasst.

11. Zusammensetzung **(B)** nach Anspruch 10, wobei der Initiator eine peroxidische Verbindung ist.

12. Zusammensetzung **(B)** nach einem der Ansprüche 6 bis 11, welche zusätzlich mindestens eine weitere Verbindung ausgewählt aus der Gruppe bestehend aus Vernetzern, Silankupplungsmitteln, Antioxidantien, Alterungsschutzmitteln, Metalloxiden, Metallhydroxiden, Weißpigmenten umfasst.

13. Zusammensetzung **(B)** nach Anspruch 12, wobei die weitere Verbindung ein Silankupplungsmittel ist.

14. Verwendung einer Zusammensetzung **(B)** nach einem der Ansprüche 6 bis 13 zur Herstellung einer Folie zur Verkapselung einer elektronischen Vorrichtung.

## Claims

1. Composition **(Z)** comprising:
(i) at least one compound **(I)** selected from the group consisting of triallyl isocyanurate, triallyl cyanurate; and
(ii) at least one compound of the chemical structure **(II)** with 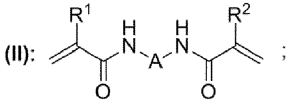 where
R¹, R² are each independently hydrogen or methyl;
A is selected from the group consisting of
unbranched or branched alkylene group which has 1 to 20 carbon atoms and in which at least one hydrogen radical may be replaced by a halogen radical and in which one or two hydrogen radicals may each be replaced by a radical selected from the group consisting of -OR³, -C(=O)NR⁴R⁵,
arylene group which has 6 to 14 carbon atoms and in which at least one hydrogen radical may be replaced by a halogen radical or an unbranched or branched alkyl radical having 1 to 10 carbon atoms and in which one or two hydrogen radicals may each be replaced by a radical selected from the group consisting of -OR⁶, -C(=O)NR⁷R⁸,
a bridging radical of the chemical structure -A¹-X-A²-;
where R³, R⁴, R⁵, R⁶, R⁷, R⁸ are each independently selected from the group consisting of hydrogen, branched or unbranched alkyl radical having 1 to 10 carbon atoms;
where A¹, A² are each independently a branched or unbranched alkylene group having 1 to 10 carbon atoms;
and where X is selected from the group consisting of -O-, -S-S-, -S-, -NR⁹- with R⁹ = unbranched or branched alkyl radical having 1 to 10 carbon atoms.

2. Composition **(Z)** according to Claim 1, wherein the compound **(I)** is triallyl isocyanurate.

3. Composition **(Z)** according to Claim 1 or 2, wherein R¹, R² are each independently hydrogen or methyl, and wherein A is selected from the group consisting of unbranched or branched alkylene group having 1 to 12 carbon atoms, phenylene, - (CH₂)₂-O-(CH₂)₂-, -CH₂-O-CH₂-.

4. Composition **(Z)** according to Claim 3, wherein R¹ = R² = hydrogen and A = -CH₂-.

5. Composition **(Z)** according to any of Claims 1 to 4, in which the proportion of all the compounds of the chemical structure **(II),** based on all the compounds **(I),** is in the range of 1.0 to 161.9 mol%.

6. Composition **(B)** comprising at least one polyolefin copolymer and a composition **(Z)** according to any of Claims 1 to 5.

7. Composition **(B)** according to Claim 6, wherein the polyolefin copolymer is an ethylene-vinyl acetate copolymer.

8. Composition **(B)** according to Claim 7, wherein the ethylene-vinyl acetate copolymer has a vinyl acetate content of 15% to 50% by weight, based on the total weight of the ethylene-vinyl acetate copolymer, determined to ASTM D 5594:1998.

9. Composition **(B)** according to any of Claims 6 to 8, in which the proportion of composition **(Z)** is 0.05% to 10% by weight, based on the mass of all the polyolefin copolymers encompassed by the composition **(B).**

10. Composition **(B)** according to any of Claims 6 to 9, additionally comprising at least one initiator selected from the group consisting of peroxidic compounds, azo compounds, photoinitiators.

11. Composition **(B)** according to Claim 10, wherein the initiator is a peroxidic compound.

12. Composition **(B)** according to any of Claims 6 to 11, additionally comprising at least one further compound selected from the group consisting of crosslinkers, silane coupling agents, antioxidants, ageing stabilizers, metal oxides, metal hydroxides, white pigments.

13. Composition **(B)** according to Claim 12, wherein the further compound is a silane coupling agent.

14. Use of a composition **(B)** according to any of Claims 6 to 13 for production of a film for encapsulation of an electronic device.

## Revendications

1. Composition (Z) comprenant :
(i) au moins un composé (I) choisi dans le groupe constitué par l'isocyanurate de triallyle, le cyanurate de triallyle ; et
(ii) au moins un composé de structure chimique (II) avec 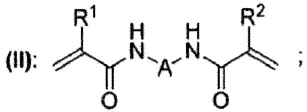 dans laquelle
R¹, R² représentent chacun indépendamment l'un de l'autre hydrogène ou méthyle ;
A est choisi dans le groupe constitué par :
un groupe alkylène non ramifié ou ramifié de 1 à 20 atomes de carbone, dans lequel au moins un radical hydrogène peut être remplacé par un radical halogène et dans lequel un ou deux radicaux hydrogène peuvent chacun être remplacés par un radical choisi dans le groupe constitué par -OR³, -C(=O)NR⁴R⁵,
un groupe arylène de 6 à 14 atomes de carbone, dans lequel au moins un radical hydrogène peut être remplacé par un radical halogène ou un radical alkyle non ramifié ou ramifié de 1 à 10 atomes de carbone, et dans lequel un ou deux radicaux hydrogène peuvent chacun être remplacés par un radical choisi dans le groupe constitué par -OR⁶, -C(=O)NR⁷R⁸,
un radical pontant de structure chimique -A¹-X-A²- ;
R³, R⁴, R⁵, R⁶, R⁷, R⁸ étant chacun choisis indépendamment les uns des autres dans le groupe constitué par l'hydrogène, un radical alkyle ramifié ou non ramifié de 1 à 10 atomes de carbone ;
A¹, A² représentant chacun indépendamment l'un de l'autre un groupe alkylène ramifié ou non ramifié de 1 à 10 atomes de carbone ;
et X étant choisi dans le groupe constitué par-O-, -S-S-, -S-, -NR⁹- avec R⁹ = radical alkyle non ramifié ou ramifié de 1 à 10 atomes de carbone.

2. Composition (Z) selon la revendication 1, dans laquelle le composé (I) est l'isocyanurate de triallyle.

3. Composition (Z) selon la revendication 1 ou 2, dans laquelle R¹, R² représentent chacun indépendamment l'un de l'autre hydrogène ou méthyl, et dans laquelle A est choisi dans le groupe constitué par un groupe alkylène non ramifié ou ramifié de 1 à 12 atomes de carbone, phénylène, - (CH₂)₂-O-(CH₂)₂-, -CH₂-O-CH₂-.

4. Composition (Z) selon la revendication 3, dans laquelle R¹ = R² = hydrogène et A = -CH₂-.

5. Composition (Z) selon l'une quelconque des revendications 1 à 4, dans laquelle la proportion de tous les composés de structure chimique (II) par rapport à tous les composés (I) se situe dans la plage allant de 1,0 à 161,9 % en moles.

6. Composition (B) comprenant au moins un copolymère de polyoléfine et une composition (Z) selon l'une quelconque des revendications 1 à 5.

7. Composition (B) selon la revendication 6, dans laquelle le copolymère de polyoléfine est un copolymère d'éthylène-acétate de vinyle.

8. Composition (B) selon la revendication 7, dans laquelle le copolymère d'éthylène-acétate de vinyle présente une teneur en acétate de vinyle de 15 à 50 % en poids, par rapport au poids total du copolymère d'éthylène-acétate de vinyle, déterminée selon ASTM D 5594:1998.

9. Composition (B) selon l'une quelconque des revendications 6 à 8, dans laquelle la proportion de la composition (Z) est de 0,05 à 10 % en poids, par rapport à la masse de tous les copolymères de polyoléfine compris par la composition (B).

10. Composition (B) selon l'une quelconque des revendications 6 à 9, qui comprend en outre au moins un initiateur choisi dans le groupe constitué par les composés peroxydiques, les composés azo, les photoinitiateurs.

11. Composition (B) selon la revendication 10, dans laquelle l'initiateur est un composé peroxydique.

12. Composition (B) selon l'une quelconque des revendications 6 à 11, qui comprend en outre au moins un composé supplémentaire choisi dans le groupe constitué par les agents de réticulation, les agents de couplage silane, les antioxydants, les agents antivieillissement, les oxydes de métaux, les hydroxydes de métaux, les pigments blancs.

13. Composition (B) selon la revendication 12, dans laquelle le composé supplémentaire est un agent de couplage silane.

14. Utilisation d'une composition (B) selon l'une quelconque des revendications 6 à 13 pour la fabrication d'un film pour l'encapsulation d'un dispositif électronique.
